# FASCICULE DE BREVET EUROPEEN

(11) **EP 0 474 529 B1**
(45) Date de publication et mention de la délivrance du brevet: **13.10.1993**
(21) Numéro de dépôt: 91402225.6
(22) Date de dépôt: 09.08.1991
(51) Int. Cl.: G11C 7/00, G11C 16/06

(54) **Circuit de précharge de lecture pour mémoire de circuit intégré**
Lesevorladungsschaltung für integrierten Speicher
Reading precharge circuit for integrated memory

(30) Priorité: 17.08.1990 FR 9010426
(43) Date de publication de la demande: 11.03.1992
(73) Titulaire: SGS-THOMSON MICROELECTRONICS S.A., 94250 Gentilly (FR)
(72) Inventeur: Conan, Bertrand, F-75116 Paris (FR)
(74) Mandataire: Schmit, Christian Norbert Marie

(56) Documents cités:
- EP-A- 0 212 451
- US-A- 4 289 982

## Description

L'invention concerne les mémoires réalisées en circuit intégré, et tout particulièrement mais non exclusivement les mémoires électriquement programmables (EPROM, EEPROM notamment).

Ces mémoires sont organisées en colonnes de cellules, chaque colonne comportant de nombreuses cellules.

Un des paramètres importants à considérer pour une mémoire est la vitesse d'accès en lecture, c'est-à-dire la possibilité de lire rapidement l'état mémorisé dans une cellule choisie. En effet, plus les mémoires comportent de cellules, plus elles tendent à être lentes. Il faut donc trouver des moyens pour accélérer la lecture pour les mémoires de grande capacité.

En particulier, une des raisons de la lenteur d'accès des mémoires de grande capacité est la constante de temps élevée due à la capacité et à la résistance d'accès des lignes de bit de la mémoire. Les lignes de bit sont les conducteurs servant à transmettre le signal représentant l'information mémorisée dans une cellule.

En principe, toute une colonne de cellules est raccordée à une même ligne de bit, de sorte que la capacité de la ligne de bit est la somme de plusieurs centaines de capacités individuelles de cellules.

Pour des mémoires à transistors à grille flottante par exemple, les cellules individuelles présentent une grande capacité vues de la ligne de bit (capacité drain-grille du transistor à grille flottante). La somme des capacités peut devenir très élevée.

Quant à la résistance d'accès, elle comprend l'ensemble des résistances en série entre une cellule à lire et l'amplificateur de lecture qui servira à lire le signal issu de cette cellule. Ces résistances comprennent les résistances de contacts entre métallisations et zones semiconductrices, les résistances des métallisations, les résistances internes source-drain de transistors de sélection placés en série dans la ligne de bit entre la cellule et l'amplificateur de lecture, etc. Ces résistances peuvent être élevées.

Il en résulte qu'on est nécessairement limité en vitesse d'accès puisque toute variation de courant ou de tension due à l'information mémorisée par la cellule sera transmise avec une certaine constante de temps.

Pour accélérer l',accès aux informations, on effectue généralement la lecture de signal en deux temps : une phase de précharge et une phase de détection (c'est-à-dire de lecture proprement dite).

Pendant la phase de précharge, qui se déclenche en général automatiquement dès qu'on détecte un changement d'adresse de cellule à lire, on applique à la ligne de bit une tension déterminée qui correspondra à celle à laquelle se fera la mesure du courant de cellule lors de la phase de lecture. Par exemple, on précharge la ligne de bit à environ 1 volt.

Lors de cette phase de lecture on injecte dans la cellule sélectionnée le courant nécessaire à la lecture et on examine la variation de tension en sortie de l'amplificateur de lecture.

Comme on procède en deux phases pour accélérer la lecture, il faut faire en sorte que la phase de précharge soit aussi courte que possible.

Un but de l'invention est d'accélérer la phase de précharge.

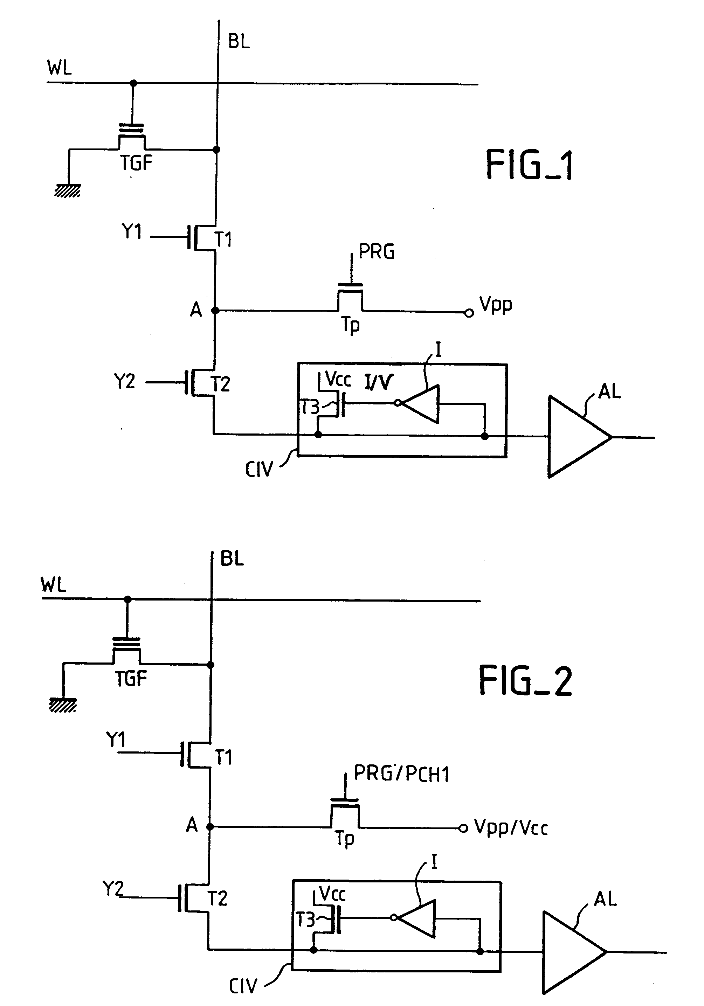

Le circuit de précharge le plus classiquement utilisé (parce qu'il est particulièrement simple) est représenté à la figure 1; il comprend, raccordé à la ligne de bit par les transistors d'accès en série T1 et T2 servant à la sélection d'une ligne de bit déterminée, un convertisseur courant-tension CIV qui a pour fonction d'une part d'asservir le potentiel de la ligne de bit à une tension de précharge prédéterminée, pendant une phase de précharge, et d'autre part de transmettre vers un amplificateur de lecture AL un signal représentant le courant traversant une cellule sélectionnée pendant une phase de lecture.

Les transistors d'accès T1 et T2, rendus conducteurs par des signaux d'adressage désignant une ligne de bit déterminée, servent à relier la ligne de bit au convertisseur courant tension pendant la lecture. Ils servent aussi à sélectionner la ligne de bit lors de phases de programmation pendant lesquelles une tension de programmation élevée Vpp est appliquée sur la ligne de bit.

Le convertisseur CIV ne doit toutefois pas recevoir la tension élevée Vpp, et c'est pourquoi cette tension Vpp est appliquée en phase de programmation au noeud entre les transistors T1 et T2, le transistor T1 étant conducteur (pour relier Vpp à la ligne de bit) alors que T2 est bloqué (pour isoler le convertisseur CIV de Vpp).

La tension Vpp n'est appliquée qu'en phase de programmation, et un transistor Tp, rendu conducteur pendant cette phase de programmation, est connecté entre une source de tension au potentiel Vpp et le noeud A de liaison entre les transistors T1 et T2.

Selon l'invention, pour accélérer la précharge, on propose de rendre conducteur le transistor Tp temporairement, au début de la phase de précharge, pour le connecter à une source d'alimentation.

Par conséquent l'invention est l'utilisation d'un moyen pour rendre temporairement conducteur, pendant une phase de précharge avant lecture, un transistor qui est par ailleurs destiné à relier une tension de programmation à la ligne de bit pendant les phases de programmation.

Un des avantages très importants de cette solution est le fait que ce transistor Tp est un transistor ayant une taille importante puisqu'il doit être capable de programmer une ou plusieurs lignes de cellules à la fois. Il permet donc de faire monter très rapidement la tension de la ligne de bit jusqu'à ce qu'elle atteigne la valeur de consigne de précharge désirée, après quoi le maintien de la tension de précharge est assuré par le circuit d'asservissement contenu dans le convertisseur CIV.

D'autres caractéristiques et avantages de l'invention apparaîtront à la lecture de la description détaillée qui suit et qui est faite en référence aux dessins annexés dans lesquels :
- la figure 1 déjà décrite représente un circuit de précharge classique;
- la figure 2 représente un circuit de précharge selon l'invention.

Le circuit de la figure 2 est très semblable à celui de la figure 1 mais le transistor de précharge Tp est rendu conducteur non seulement pendant une phase de programmation d'une information dans une cellule de la mémoire, mais aussi pendant une phase de précharge (au moins au début de cette phase) avant lecture de l'état mémorisé dans une cellule.

C'est pourquoi on a représenté, appliqué à la grille du transistor de programmation Tp, un signal PRG/PCH1, signifiant que le transistor est rendu conducteur par ce signal pendant une phase PRG (programmation) et pendant une phase PCH1 qui représente tout ou partie d'une phase de précharge PCH.

On notera que pendant la phase de programmation, le transistor Tp reçoit sur son drain une tension de programmation élevée Vpp. Mais pendant la phase de précharge, la tension présente sur le drain sera en général une tension d'alimentation normale Vcc, plus faible que Vpp. Toutefois, le circuit fonctionnerait aussi si Vpp restait appliqué sur le drain pendant la phase de précharge, à condition toutefois que le convertisseur CIV puisse supporter Vpp.

La source du transistor Tp est reliée au noeud A entre les transistors en série T1 et T2. T1 est par ailleurs relié à la ligne de bit BL; T2 est relié par ailleurs à l'entrée du convertisseur CIV dont la sortie est reliée à un amplificateur de lecture AL.

Le transistor T1 est rendu conducteur par un signal d'adressage Y1 servant à désigner la ligne de bit BL parmi d'autres lignes de bit de la mémoire (ceci aussi bien en mode de lecture qu'en mode d'écriture).

Le transistor T2 est rendu conducteur par un signal d'adressage servant à désigner la ligne de bit BL, mais seulement en mode de lecture (précharge et lecture proprement dite).

La cellule à lire est, dans cet exemple, un transistor EPROM à grille flottante dont le drain est relié à la ligne de bit BL et dont la grille est reliée à une ligne de mot WL.

Le convertisseur CIV a là encore deux rôles :
a) pendant la phase de précharge PCH, établir une tension de précharge (par exemple environ 1 volt), à travers les transistors T1 et T2, sur la ligne de bit et asservir la tension de précharge à une valeur de consigne;
b) pendant la phase de lecture proprement dite, transmettre à l'amplificateur de lecture un signal représentant l'information stockée dans la cellule sélectionnée.

Dans sa réalisation la plus simple, le convertisseur CIV comprend un simple transistor T3 ayant son drain relié à une alimentation Vcc, sa source reliée au transistor T2 donc à la ligne de bit, et sa grille reliée à sa source par l'intermédiaire d'un inverseur I.

Ce montage très simple constitue un asservissement établissant sur la source de T3 une tension de précharge liée aux caractéristiques technologiques du transistor T3 et de l'inverseur I.

Au début de la phase de précharge, le potentiel de précharge de la ligne de bit tend exponentiellement vers la valeur de consigne désirée. Il faut donc attendre assez longtemps avant de passer à la phase de lecture proprement dite qui consiste à établir sur la ligne de mot l'ordre de lecture.

Selon l'invention, on établit la précharge avec une pente de croissance beaucoup plus forte en rendant conducteur le transistor Tp qui est de grande dimension et qui est relié à ce moment à la tension d'alimentation Vcc.

On atteint très rapidement la tension désirée sur la ligne de bit et on peut alors bloquer le transistor Tp par un dispositif de régulation non représenté, le convertisseur CIV prenant alors le relais pour asservir la ligne de bit au potentiel désiré. On utilise donc un signal de commande PCH1 plus court que la durée de la phase de précharge PCH pour rendre conducteur le transistor Tp.

Il est possible aussi d'agir sur la valeur de la tension d'alimentation du drain de Tp pour contrôler le niveau de la tension de la ligne de bit à la fin de la phase PCH1.

Le circuit selon l'invention permet un temps d'accès réduit en lecture pour des mémoires de grande capacité (plusieurs mégabits).

## Revendications

1. Mémoire en circuit intégré, comprenant un circuit de précharge et de lecture (CIV) permettant d'appliquer à une ligne de bit une tension de précharge pendant une phase de précharge précédant une phase de lecture, et un transistor (Tp) pour appliquer à la ligne de bit (BL) une tension de programmation Vpp pendant une phase de programmation, caractérisé en ce qu'elle comporte des moyens pour rendre le transistor (Tp) conducteur au début de la phase de précharge et pour relier la ligne de bit par ce transistor à une source de tension.

2. Mémoire selon la revendication 1, caractérisée en ce que le drain du transistor est relié à une tension d'alimentation normale Vcc pendant la phase de précharge et à une tension d'alimentation plus élevée Vpp pendant la phase de programmation.

## Patentansprüche

1. Integrierte Speicherschaltung mit einer Vorladungs- und Leseschaltung (CIV), mit deren Hilfe an eine Bit-Leitung eine Vorladungsspannung während einer Vorladungsphase angelegt werden kann, die einer Lesephase vorangeht, und einem Transistor (Tp) zum Anlegen einer Programmierspannung Vpp an die Bit-Leitung (BL) während einer Programmierphase, dadurch gekennzeichnet, daß sie Mittel enthält, um den Transistor (Tp) am Anfang der Vorladungsphase leitend zu machten und um die Bit-Leitung durch diesen Transistor mit einer Spannungsquelle zu verbinden.

2. Speicherschaltung nach Anspruch 1, dadurch gekennzeichnet, daß der Drain-Anschluß des Transistors während der Vorladungsphase mit einer normalen Versorgungsspannung Vcc verbunden ist und während der Programmierphase mit einer höheren Versorgungsspannung Vpp verbunden ist.

## Claims

1. Integrated-circuit memory, comprising a precharging and reading circuit (CIV) making it possible to apply a precharging voltage to a bit line during a precharging stage preceding a reading stage, and a transistor (Tp) for applying a programming voltage Vpp to the bit line (BL) during a programming stage, characterised in that it includes means for making the transistor (Tp) conductive at the beginning of the precharging stage and for connecting the bit line, through this transistor, to a voltage source.

2. Memory according to Claim 1, characterised in that the transistor drain is connected to a normal power supply voltage Vcc during the precharging stage and to a higher power supply voltage (Vpp) during the programming stage.
